(19) Europäisches Patentamt / European Patent Office / Office européen des brevets

(11) **EP 2 524 568 B1**

(12) **EUROPEAN PATENT SPECIFICATION**

(45) Date of publication and mention of the grant of the patent:
**31.08.2016 Bulletin 2016/35**

(51) Int Cl.:
*H04L 25/06* *(2006.01)*     *H04L 25/08* *(2006.01)*
*H04L 27/00* *(2006.01)*     *H03F 1/30* *(2006.01)*
*H03F 1/32* *(2006.01)*      *H03F 3/08* *(2006.01)*
*H03F 3/19* *(2006.01)*      *H03F 3/24* *(2006.01)*
*H04W 24/02* *(2009.01)*

(21) Application number: **10848623.4**

(22) Date of filing: **21.12.2010**

(86) International application number:
**PCT/IB2010/003455**

(87) International publication number:
**WO 2011/098861 (18.08.2011 Gazette 2011/33)**

(54) **HIGH EFFICIENCY, REMOTELY RECONFIGURABLE REMOTE RADIO HEAD UNIT SYSTEM AND METHOD FOR WIRELESS COMMUNICATIONS**

LEISTUNGSSTARKES FERNKONFIGURIERBARES FERNFUNKKOPFSYSTEM UND VERFAHREN FÜR DIE DRAHTLOSE KOMMUNIKATION

SYSTÈME D'UNITÉ TÊTE RADIO DISTANTE, RECONFIGURABLE À DISTANCE, À RENDEMENT ÉLEVÉ ET PROCÉDÉ POUR COMMUNICATIONS SANS FIL

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **21.12.2009   US 288844 P**
**21.12.2009   US 288847 P**
**21.12.2009   US 288840 P**
**21.12.2009   US 288838 P**

(43) Date of publication of application:
**21.11.2012   Bulletin 2012/47**

(73) Proprietor: **Dali Systems Co. Ltd**
**KY1-1104 (KY)**

(72) Inventors:
• **STAPLETON, Shawn Patrick**
**Burnaby, BC V5C 4C6 (CA)**
• **KIM, Wan Jong**
**Coquitlam, BC V3K 2T3 (CA)**
• **XIAO, Ying**
**Coquitlam, BC V3B 6K4 (CA)**
• **CHO, Kyoung Joon**
**Coquitlam, BC V3K 6R9 (CA)**

(74) Representative: **Diehl & Partner GbR**
**Patentanwälte**
**Erika-Mann-Strasse 9**
**80636 München (DE)**

(56) References cited:
EP-A1- 0 544 117        WO-A1-01/08295
WO-A1-2004/057758       WO-A1-2008/154077
WO-A1-2009/046627       CA-A1- 2 616 323
US-A1- 2003 179 829     US-A1- 2005 026 574
US-A1- 2009 163 156     US-A1- 2009 184 763
US-A1- 2009 232 191     US-A1- 2010 254 299
US-A1- 2011 150 130     US-B2- 7 362 125
US-B2- 7 583 754        US-B2- 7 593 450

**Description**

**FIELD OF THE INVENTION**

The present invention generally relates to wireless communication systems using power amplifiers and remote radio head units (RRU or RRH). More specifically, the present invention relates to RRU which are part of a distributed base station in which all radio-related functions are contained in a small single unit that can be deployed in a location remote from the main unit. Multi-mode radios capable of operating according to GSM, HSPA, LTE, and WiMAX standards and advanced software configurability are key features in the deployment of more flexible and energy-efficient radio networks. The present invention can also serve multi-frequency bands within a single RRU to economize the cost of radio network deployment.

Document US 2009/184763 A1 discloses an apparatus for digital pre-distortion having plural amplifiers, plural couplers, a switch, a shared feedback path and plural processors. The plural amplifiers amplify input signals directed to each of the transmission paths. The plural couplers couple amplified signals on respective transmission paths. The switch outputs at least of the amplified signals coupled on the respective transmission path. The shared feedback path provides the amplified signal output from the switch to plural processors, which in turn compare the feedback signal with the input signal and pre-distort the input signal such that the input signal and the amplified signal have a linear relation with each other.

**BACKGROUND OF THE INVENTION**

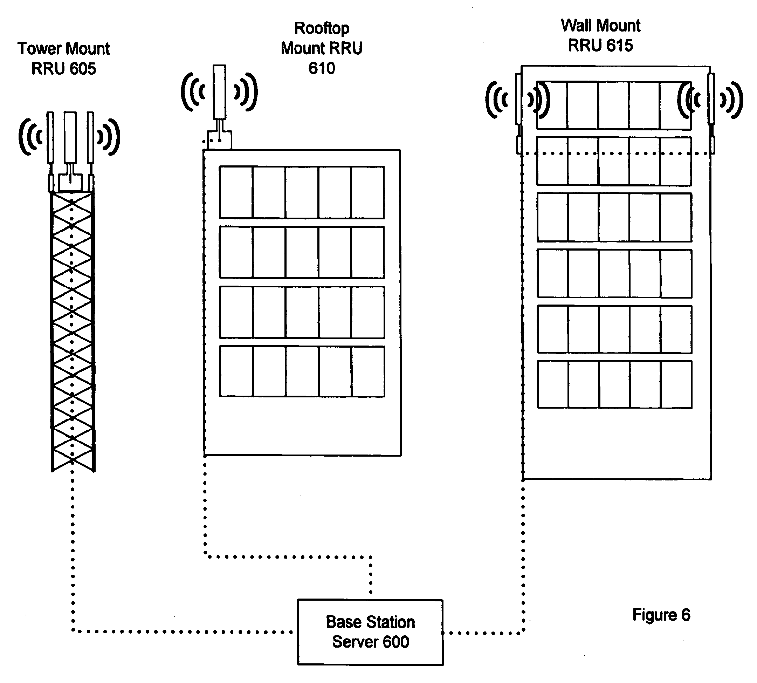

Wireless and mobile network operators face the continuing challenge of building networks that effectively manage high data-traffic growth rates. Mobility and an increased level of multimedia content for end users require end-to-end network adaptations that support both new services and the increased demand for broadband and flat-rate Internet access. In addition, network operators must consider the most cost-effective evolution of the networks towards 4G. Wireless and mobile technology standards are evolving towards higher bandwidth requirements for both peak rates and cell throughput growth. The latest standards supporting this are HSPA+, WiMAX, TD-SCDMA and LTE. The network upgrades required to deploy networks based on these standards must balance the limited availability of new spectrum, leverage existing spectrum, and ensure operation of all desired standards. This all must take place at the same time during the transition phase, which usually spans many years. Distributed open base station architecture concepts have evolved in parallel with the evolution of the standards to provide a flexible, cheaper, and more scalable modular environment for managing the radio access evolution, Figure 6. For example, the Open Base Station Architecture Initiative (OBSAI), the Common Public Radio Interface (CPRI), and the IR Interface standards introduced standardized interfaces separating the Base Station server and the remote radio head part of a base station by an optical fiber.

The RRU concept constitutes a fundamental part of a state-of-the-art base station architecture. However, RRUs to-date are power inefficient, costly and inflexible. Their poor DC to RF power conversion insures that they will have a large mechanical housing. The RRU demands from the service providers are also for greater flexibility in the RRU platform. As standards evolve, there is a need for a software upgradable RRU. Today RRUs lack the flexibility and performance that is required by service providers. The RRU performance limitations are driven in part by the poor power efficiency of the RF amplifiers. Thus there has been a need for an efficient, flexible RRU architecture that is field reconfigurable.

**SUMMARY OF THE INVENTION**

Accordingly, the present invention has been made in view of the above problems in the prior art, and it is an object of the present invention to provide a high performance and cost effective method of multi-frequency bands RRU systems enabled by high linearity and high efficiency power amplifiers for wideband communication system applications. The present disclosure enables a RRU to be field reconfigurable, and supports multi-modulation schemes (modulation agnostic); multi-carriers, multi-frequency bands, and multi-channels.

To achieve the above objects, according to the present invention, the technique is generally based on the method of adaptive digital predistortion to linearize RF power amplifiers. Various embodiments of the invention are disclosed, including single band, dual band, and multi-band RRU's. Another embodiment is a multi-band multi-channel RRU. In an embodiment, the combination of crest factor reduction, PD, power efficiency boosting techniques as well as coefficient adaptive algorithms are utilized within a PA system. In another embodiment, analog quadrature modulator compensation structure is also utilized to enhance performance.

The embodiments of the present invention are able to monitor the fluctuation of the power amplifier characteristics and to self-adjust by means of a self-adaptation algorithm. One such self-adaptation algorithm presently disclosed is called a digital predistortion algorithm, which is implemented in the digital domain.

Applications of the present invention are suitable for use with all wireless base-stations, remote radio heads, distributed base stations, distributed antenna systems, access points, mobile equipment and wireless terminals, portable wireless devices, and other wireless communication systems such as microwave and satellite communications. The present invention is also field upgradable through a link such as an Ethernet connection to a remote computing center.

## THE FIGURES

Further objects and advantages of the present invention can be more fully understood from the following detailed description taken in conjunction with the accompanying drawings in which:

Figure 1 is a block diagram showing the basic form of a Remote Radio head unit system.

Figure 2 is a block diagram showing a multi-channel Remote Radio Head Unit according to one embodiment of the present invention.

Figure 3 is a block diagram showing polynomial based predistortion in a Remote Radio head system of the present invention.

Figure 4 is a block diagram of the digital predistortion algorithm applied for self-adaptation in a remote radio head unit system of the present invention.

Figure 5 illustrates an analog modulator compensation block.

Figure 6 depicts schematically a variety of potential installation schemes for an RRU-based system architecture.

Figure 7 depicts a three-sector arrangement of an RRU system architecture comprising optical links to a base station server.

Figure 8 shows in block diagram form various DSP-based functions including crest factor reduction and digital predistortion.

Figure 9 is a Digital Hybrid Module with either an RF input signal or a baseband modulated signal or an optical interface according to another embodiment of the present invention.

Figure 10 is a Dual Channel Remote Radio head block diagram showing a digital hybrid module with an optical interface according to another embodiment of the present invention.

Figure 11 is an alternative Dual Channel Remote Radio Head block diagram showing a digital hybrid module with an optical interface according to another embodiment of the present

Figure 12 is an 8 channel Dual Band Remote Radio Head block diagram showing a digital hybrid module with an optical interface, and further comprises a calibration algorithm for insuring that each power amplifier output is time-aligned, phase-aligned and amplitude-aligned with respect to each other.

## GLOSSARY

Acronyms used herein have the following meanings:

| | |
|---|---|
| ACLR | Adjacent Channel Leakage Ratio |
| ACPR | Adjacent Channel Power Ratio |
| ADC | Analog to Digital Converter |
| AQDM | Analog Quadrature Demodulator |
| AQM | Analog Quadrature Modulator |
| AQDMC | Analog Quadrature Demodulator Corrector |
| AQMC | Analog Quadrature Modulator Corrector |
| BPF | Bandpass Filter |
| CDMA | Code Division Multiple Access |
| CFR | Crest Factor Reduction |
| DAC | Digital to Analog Converter |
| DET | Detector |
| DHMPA | Digital Hybrid Mode Power Amplifier |
| DDC | Digital Down Converter |
| DNC | Down Converter |
| DPA | Doherty Power Amplifier |
| DQDM | Digital Quadrature Demodulator |
| DQM | Digital Quadrature Modulator |
| DSP | Digital Signal Processing |
| DUC | Digital Up Converter |
| EER | Envelope Elimination and Restoration |

| EF | Envelope Following |
|---|---|
| ET | Envelope Tracking |
| EVM | Error Vector Magnitude |
| FFLPA | Feedforward Linear Power Amplifier |
| FIR | Finite Impulse Response |
| FPGA | Field-Programmable Gate Array |
| GSM | Global System for Mobile communications |
| I-Q | In-phase / Quadrature |
| IF | Intermediate Frequency |
| LINC | Linear Amplification using Nonlinear Components |
| LO | Local Oscillator |
| LPF | Low Pass Filter |
| MCPA | Multi-Carrier Power Amplifier |
| MDS | Multi-Directional Search |
| OFDM | Orthogonal Frequency Division Multiplexing |
| PA | Power Amplifier |
| PAPR | Peak-to-Average Power Ratio |
| PD | Digital Baseband Predistortion |
| PLL | Phase Locked Loop |
| QAM | Quadrature Amplitude Modulation |
| QPSK | Quadrature Phase Shift Keying |
| RF | Radio Frequency |
| RRU | Remote Radio Head Unit |
| SAW | Surface Acoustic Wave Filter |
| SERDES | Serializer/Deserializer |
| UMTS | Universal Mobile Telecommunications System |
| UPC | Up Converter |
| WCDMA | Wideband Code Division Multiple Access |
| WLAN | Wireless Local Area Network. |

## DETAILED DESCRIPTION OF THE INVENTION

The present invention is a novel RRU system that utilizes an adaptive digital predistortion algorithm. The present invention is a hybrid system of digital and analog modules. The interplay of the digital and analog modules of the hybrid system both linearize the spectral regrowth and enhance the power efficiency of the PA while maintaining or increasing the wide bandwidth. The present invention, therefore, achieves higher efficiency and higher linearity for wideband complex modulation carriers.

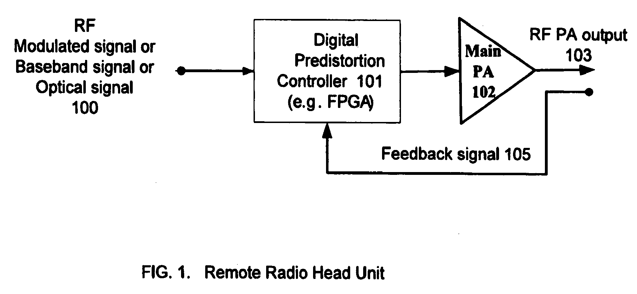

Figure 1 is a high level block diagram showing the basic system architecture of what is sometimes referred to as a Remote Radio Head Unit, or RRU, which can be thought of, at least for some embodiments, as comprising digital and analog modules and a feedback path. The digital module is the digital predistortion controller 101 which comprises the PD algorithm, other auxiliary DSP algorithms, and related digital circuitries. The analog module is the main power amplifier 102, other auxiliary analog circuitries such as DPA, and related peripheral analog circuitries of the overall system. The present invention operates as a "black box", plug-and-play type system because it accepts RF modulated signal 100 as its input, and provides a substantially identical but amplified RF signal 103 as its output, therefore, it is RF-in/RF-out. Baseband input signals can be applied directly to the Digital Predistorter Controller according to one embodiment of the present invention. An Optical input signal can be applied directly to the Digital Predistorter Controller according to one embodiment of the present invention. The feedback path essentially provides a representation of the output signal to the predistortion controller 101. The present invention is sometimes referred to as a Remote Radio head Unit (RRU) hereinafter.

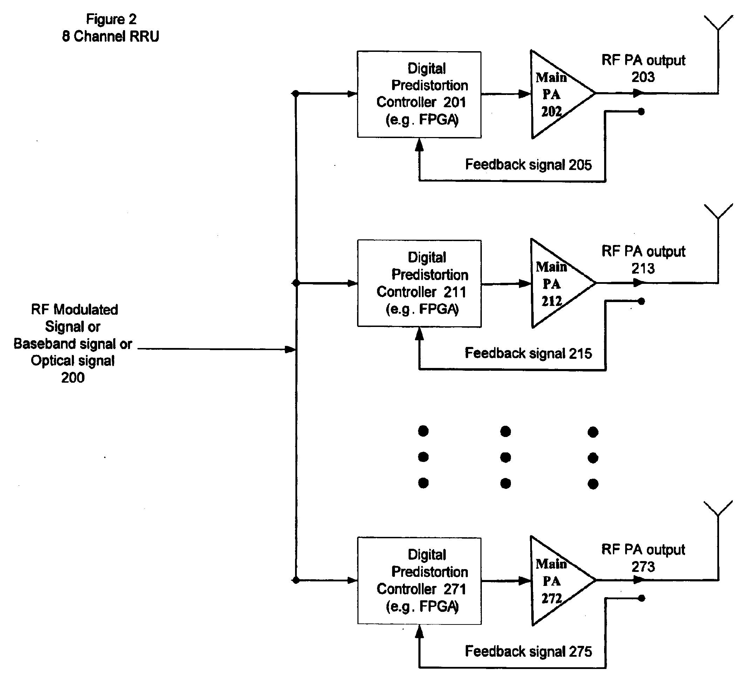

Figure 2 illustrates in schematic block diagram form an embodiment of an eight channel (or n channel) RRU in which an input signal 200 is provided Depending on the implementation, the input signal can take the form of an RF modulated signal, a baseband signal, or an optical signal. The input signal 200 is fed to a plurality of channels, where each channel includes a digital predistortion (DPD) controller, indicated at 201, 211 and 271, respectively. The DPD can be implemented in an FPGA in at least some embodiments. For each channel, the DPD outputs are fed to associated PA's 202, 212 and 272, respectively, and the PA outputs 203, 213 and 273 are fed back to that channel's DPD's.

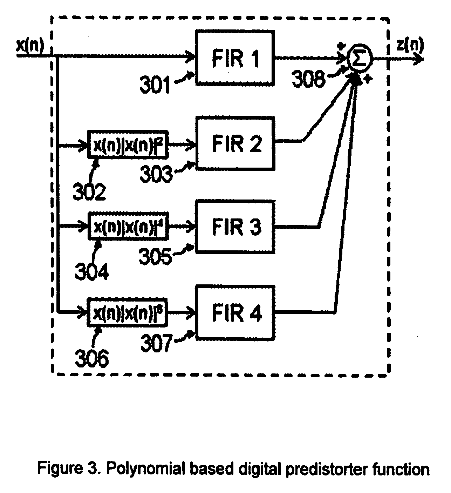

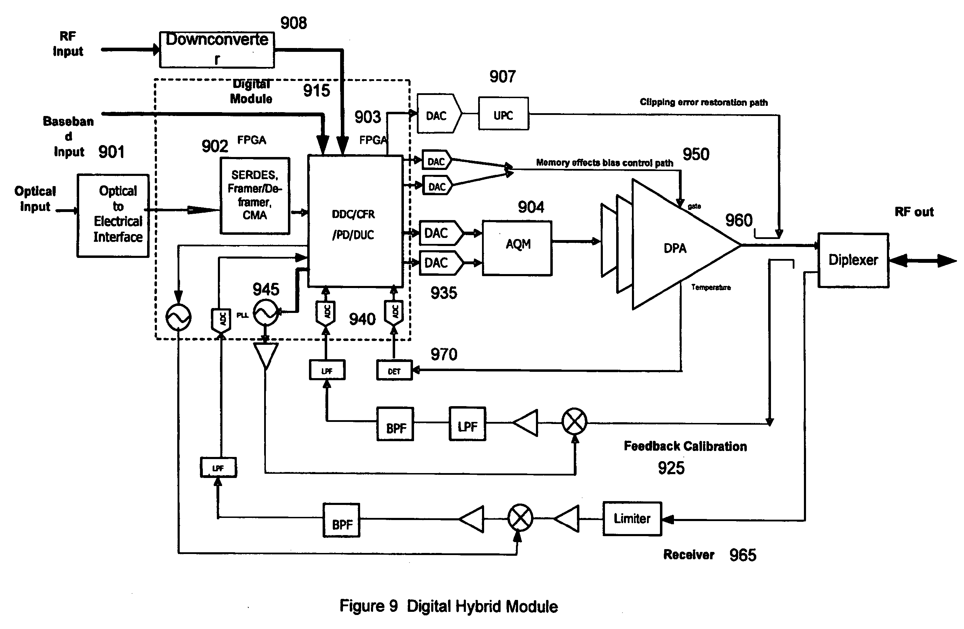

Figure 3 illustrates a polynomial-based digital predistorter function in the RRU system of the present invention. The PD in the present invention generally utilizes an adaptive LUT-based digital predistortion system. More specifically, the PD illustrated in FIG. 3, and in embodiments disclosed from Figures 9-12 discussed hereinafter, are processed in the digital processor by an adaptive algorithm, presented in U.S. Patent application S.N. 11/961,969, entitled A Method for Baseband Predistortion Linearization in Multi-Channel Wideband Communication Systems. The PD for the RRU system in FIG. 3. has multiple finite impulse response (FIR) filters, that is, FIR1 301, FIR2 303, FIR3 305, and FIR4 307. The PD also contains the third order product generation block 302, the fifth order product generation block 304, and the seventh order product generation block 306. The output signals from FIR filters are combined in the summation block 308. Coefficients for multiple FIR filters are updated by the digital predistorter algorithm based on the error between the reference input signal and the amplified power output signal.

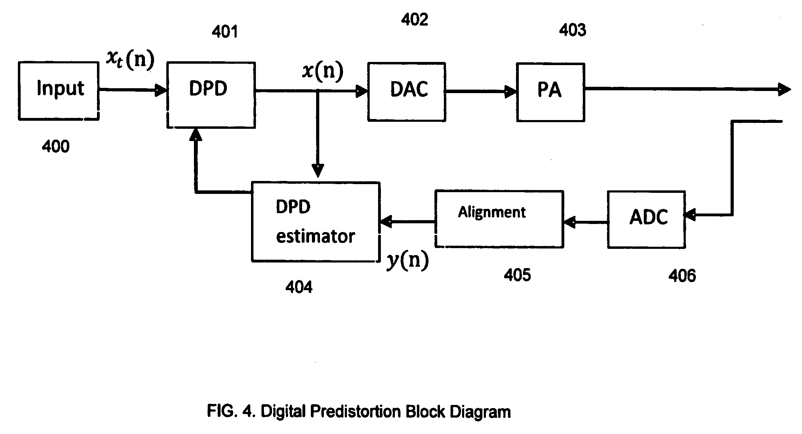

Figure 4 shows in block diagram form additional details of an embodiment including a DPD in accordance with the present invention and is discussed in greater detail hereinafter. In general, the input 400 is provided to the DPD 401. The output of the DPD is fed to a DAC 402 and thence to the PA 403. A feedback signal from the output of the PA is received by ADC 406, and the digital form is supplied to alignment logic 405, after which the aligned signal is provided to DPD estimator logic 404, which also receives an input from the output of the DPD 401. The output of the DPD estimator is then fed back to the DPD 401.

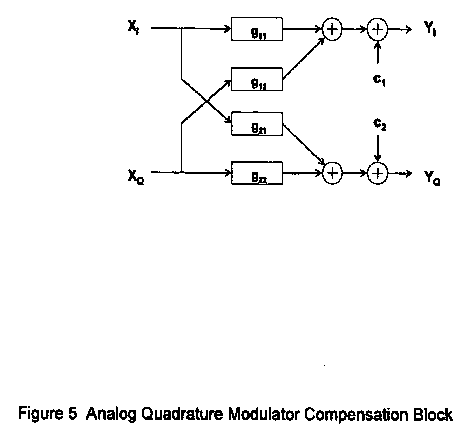

Figure 5 illustrates an analog modulator compensation block. The input signal is separated into an in-phase component $X_I$ and a quadrature component $X_Q$. The analog quadrature modulator compensation structure comprises four real filters {g11, g12, g21, g22} and two DC offset compensation parameters c1, c2. The DC offsets in the AQM will be compensated by the parameters c1, c2. The frequency dependence of the AQM will be compensated by the filters {g11, g12, g21, g22}. The order of the real filters is dependent on the level of compensation required. The output signals $Y_I$ and $Y_Q$ will be presented to an AQM's in-phase and quadrature ports, discussed hereinafter in connection with Figure 9.

Figure 6 illustrates a plurality of possible implementations of an RRU-based system architecture, in with a base station server 600 is connected to, for example, a tower-mounted RRU 605, a rooftop-mounted RRU 610, and/or a wall-mounted RRU 615.

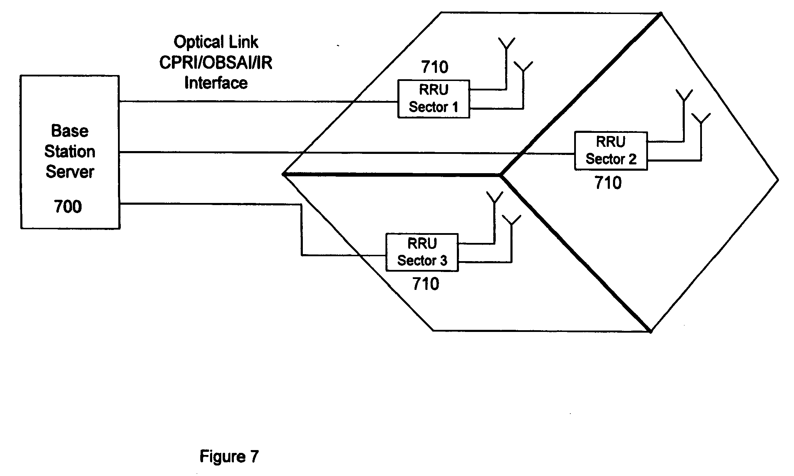

Figure 7 illustrates an embodiment of a three-sector implementation of an RRU-based system architecture, in which a base station server 700 is optically linked to a plurality of RRU's 710 to provide adequate coverage for a site.

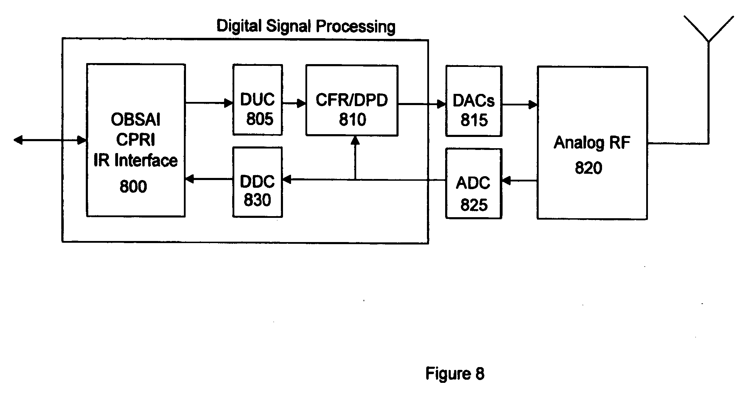

Figure 8 illustrates in simplified form an embodiment of the DSP functionality of some implementations of the present invention. An input signal is fed to an interface 800, which can take several forms including OBSAI, CPRI or IR. The incoming signal is fed to a digital up-converter (DUC) 805 and then to CFR/DPD logic 810, such as an FPGA. The output of the CFR/DPD logic 810 is then supplied to a DAC 815. The DAC provides an output signal to the analog RF portion 820 of the system, which in turn provides a feedback signal to a ADC 825, and back through the DSP block in the form of inputs to the CFR/DPD and a DDC 830. The DDC outputs a signal to the interface 800, which in turn can provide an output.

Figure 9 is a block diagram showing a more sophisticated embodiment of a RRU system, where like elements are indicated with like numerals. The embodiment of Figure 9 applies crest factor reduction (CFR) prior to the PD with an adaptation algorithm in one digital processor, so as to reduce the PAPR, EVM and ACPR and compensate the memory effects and variation of the linearity due to the temperature changing of the PA. The digital processor can take nearly any form; for convenience, an FPGA implementation is shown as an example, but a general purpose processor is also acceptable in many embodiments. The CFR implemented in the digital module of the embodiments is based on the scaled iterative pulse cancellation presented in US patent application SN 61/041, 164, filed March 31, 2008, entitled An Efficient Peak Cancellation Method For Reducing The Peak-To-Average Power Ratio In Wideband Communication Systems, incorporated herein by reference. The CFR is included to enhance performance and hence optional. The CFR can be removed from the embodiments without affecting the overall functionality.

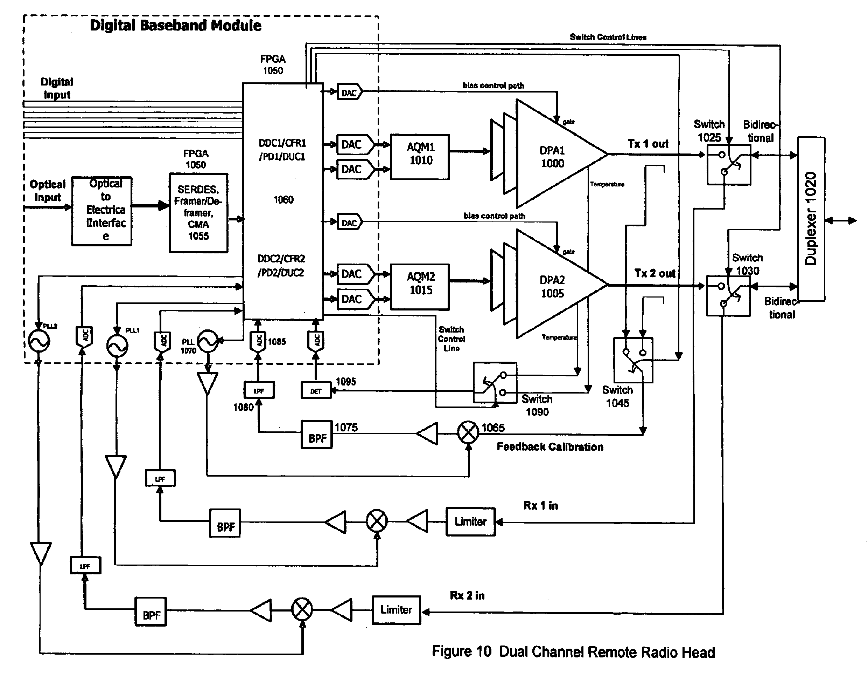

Figure 9 is a block diagram showing a RRU system according to one embodiment of the present invention. RRU systems typically comprise three primary blocks: power amplifiers, baseband processing and an optical interface. The optical interface contains an optical to electrical interface for the transmit/receive mode. The optical interface 901, shown in Figure 9, is coupled to a FPGA. The FPGA 902 performs the functions of SERDES/Framer/De-Framer/Control and Management. This FPGA 902 interfaces with another FPGA 903 that performs the following Digital Signal Processing tasks: Crest Factor Reduction/ Digital Upconversion/Digital Downconversion and Digital Predistortion. Another embodiment will be to integrate 902 with 903 in a single FPGA. The Serializer/De-serializer (SERDES) module converts the high speed serial bit stream from the optical to electrical receiver to a parallel bit stream. The De-Framer decodes the parallel bit stream and extracts the In-phase and Quadrature (I/Q) modulation and delivers this to the digital signal processing module 903. The Control and Management module extracts the control signals from the parallel bit stream and performs tasks based on the requested information. The received I/Q data from the optical interface is frequency translated to an Intermediate Frequency in the Digital Upconverter Module (DUC). This composite signal then undergoes Crest Factor Reduction (CFR) in order to reduce the peak to average power ratio. The resultant signal is then applied to a Digital Predistorter in order to compensate for the distortion in the Power Amplifier module 905. The RRU operates in a receive mode as well as a transmit mode. The RRU receives the signal from the output duplexer and passes this signal to the Rx path or paths, depending on the number of channels. The received signal is frequency translated to an Intermediate Frequency (IF) in the receiver (Rx1 and Rx2 in Figure 10). The IF signal is further downconverted using a Digital Downconverter (DDC) module and demodulated into the In-phase and quadrature components. The recovered I/Q signal is then sent to the Framer module/ SERDES and prepared for transmission over the optical interface.

The system of Figure 9 has a multi-mode of RF or multi-carrier digital signal, which can be optical, at the input, and an RF signal at the output 910. The multi-mode of the signal input allows maximum flexibility: RF-in (the "RF-in Mode") or baseband digital-in (the "Baseband-in Mode") or optical input (the "Optical-in Mode"). The system shown in Figure 9 comprises three key portions: a reconfigurable digital (hereinafter referred as "FPGA-based Digital") module 915, a power amplifier module 960, a receiver 965 and a feedback path 925.

The FPGA-based Digital part comprises either one of two digital processors 902,903 (e.g. FPGA), digital-to-analog converters 935 (DACs), analog-to-digital converters 940 (ADCs), and a phase-locked loop (PLL) 945. Since the system shown in Figure 9 has a multi-input mode, the digital processor has three paths of signal processing. For the baseband signal input path, the digital processor has implemented a digital up-converter (DUC), CFR, and a PD. For the optical input path, SERDES, Framer/ Deframer, digital up-converter (DUC), CFR, and PD are implemented. For the RF input path, analog downconverter, DUC, CFR and PD are implemented.

The Baseband-in Mode of Figure 9 contains the I-Q signals. Digital data streams from multi-channels as I-Q signals are coming to the FPGA-based Digital module and are digitally up-converted to digital IF signals by the DUC. These IF signals are then passed through the CFR block so as to reduce the signal's PAPR. This PAPR suppressed signal is digitally predistorted in order to pre-compensate for nonlinear distortions of the power amplifier.

In either input mode, the memory effects due to self-heating, bias networks, and frequency dependencies of the active device are compensated by the adaptation algorithm in the PD, as well. The coefficients of the PD are adapted, by a wideband feedback which requires a very high speed ADC. The predistorted signal is passed through a DQM in order to generate the real signal and then converted to an IF analog signal by the DACs. As disclosed above, the DQM is not required to be implemented in the FPGA, or at all, in all embodiments. If the DQM is not used in the FPGA, then the AQM Implementation can be implemented with two DACs to generate real and imaginary signals 935, respectively. The gate bias voltage 950 of the power amplifier is determined by the adaptation algorithm and then adjusted through the DACs 935 in order to stabilize the linearity fluctuations due to the temperature changes in the power amplifier. The PLL 945 sweeps the local oscillation signal for the feedback part in order to translate the RF output signal to baseband, for processing in the Digital Module.

The power amplifier part comprises an AQM for receiving real and complex signals (such as depicted in the embodiments shown in Figure 9) from the FPGA-based Digital module, a high power amplifier with multi-stage drive amplifiers, and a temperature sensor. In order to improve the efficiency performance of the DHMPA system, efficiency boosting techniques such as Doherty, Envelope Elimination and Restoration (EER), Envelope Tracking (ET), Envelope Following (EF), and Linear amplification using Nonlinear Components (LINC) can be used, depending upon the embodiment. These power efficiency techniques can be mixed and matched and are optional features to the fundamental RRU system. One such Doherty power amplifier technique is presented in commonly assigned U.S. Provisional Patent Application SN 60/925,577, filed April 23, 2007, entitled N-Way Doherty Distributed Power Amplifier, incorporated herein by reference. To stabilize the linearity performance of the amplifier, the temperature of the amplifier is monitored by the temperature sensor and then the gate bias of the amplifier is controlled by the FPGA-based Digital part.

The feedback portion comprises a directional coupler, a mixer, a low pass filter (LPF), gain amplifiers and, and a band pass filter (BPF),. Depending upon the embodiment, these analog components can be mixed and matched with other analog components. Part of the RF output signal of the amplifier is sampled by the directional coupler and then down converted to an IF analog signal by the local oscillation signal in the mixer. The IF analog signal is passing through the LPF, the gain amplifier, and the BPF which can capture the out-of-band distortions. The output of the BPF is provided to the ADC of the FPGA-based Digital module in order to determine the dynamic parameters of the PD depending on output power levels and asymmetrical distortions due to the memory effects. In addition, temperature is also detected by the DET 970 to calculate the variation of linearity and then adjust gate bias voltage of the PA. More details of the PD algorithm and self-adaptation feedback algorithm can be appreciated from Figure 3, which shows a polynomial-based predistortion algorithm and from Figure 4, which shows the primary adaptive predistorter blocks which can be used in some embodiments of the invention.

In the case of a strict EVM requirement for broadband wireless access such as WiMAX or other OFDM based schemes (EVM < 2.5%), the CFR in the FPGA-based Digital part is only able to achieve a small reduction of the PAPR in order to meet the strict EVM specification. In general circumstances, this means the CFR's power efficiency enhancement capability is limited. In some embodiments of the present invention, a novel technique is included to compensate the in-band distortions from CFR by use of a "Clipping Error Restoration Path" 907, hence maximizing the RRU system power efficiency in those strict EVM environments. As noted above, the Clipping Error Restoration Path has an additional DAC in the FPGA-based Digital portion and an extra UPC in the power amplifier part. The Clipping Error Restoration Path can allow compensation of in-band distortions resulting from the CFR at the output of the power amplifier. Further, any delay mismatch between the main path and the Clipping Error Restoration Path can be aligned using digital delay in the FPGA.

While Figure 9 illustrates a RRU system implemented with AQM, according to another embodiment of the present invention, the system of Figure 9 can also comprise a digital processor which has implemented therein CFR, PD, and an analog quadrature modulator corrector (AQMC).

Still further, the system of Figure 9 can alternatively be configured to be implemented with AQM and an AQM-based Clipping Error Restoration Path. In such an arrangement, the Clipping Error Restoration Path can be configured to have two DACs in the FPGA-based Digital part and an AQM in lieu of the UPC in the power amplifier part.

Figure 10 is a block diagram showing a dual channel RRU implemented with two power amplifiers 1000 and 1005, respectively, for two distinct bands provided from AQM1 1010 and AQM2 1015. A duplexer 1020 is used to combine the two power amplifier outputs and provide the combined output to the antenna [not shown]. Switches 1025 and 1030 are used to isolate the transmit signals from the received signals as occurs in a Time Division Synchronous Code Division Multiple Access (TD-SCDMA) modulation. Feedback signals 1035 and 1040, derived from the output of PA's 1000 and 1005, are each provided to an additional switch 1045, which is toggled at appropriate times to permit feedback calibration of each PA with only a single FPGA 1050. In the embodiment shown, the FPGA 1050 comprises two blocks: SERDES Framer/Deframer and CMA, indicated at 1055, and a block 1060 comprising DDC1/CFR1/PDC1/DUC1 as well as DDC2/CFR2/PDC2/DUC2, with block 1060 controlling the switching timing of the associated switches. The feedback signals 1035 and 1040 are fed back to the block 1060 first through adder 1065, where they are combined with phase-locked-loop signal 1070, and then through band pass filter 1075, low pass filter 1080 and ADC 1085. In addition, temperature sensor signals from PA's 1000 and 1005 are fed back to the block 1060 through toggle switch 1090 and detector 1095 so that the predistortion coefficients can include temperature compensation. The toggling of the switches 1045 and 1090 is synchronized to ensure that the output and temperature signals of each PA are provided to block 1060 at the appropriate times Another embodiment of the RRU extends its application to multi-frequency bands. In another embodiment, a multi-frequency band (i.e., two or more bands) implementation comprises adding additional channelized power amplifiers in parallel. The output of the additional power amplifiers is combined in an N by 1 duplexer and fed to a single antenna, although multiple antennae can also be utilized in some embodiments. Another embodiment of the multi-frequency band RRU combines two or more frequency bands in one or more of the power amplifiers.

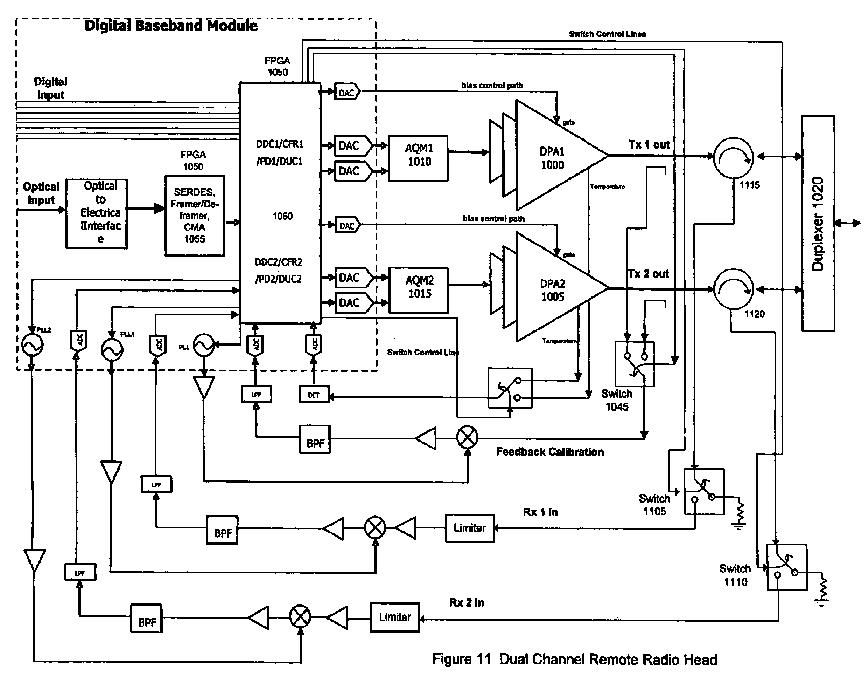

Figure 11 is a block diagram showing another embodiment of the dual channel RRU. In this embodiment the Rx switches 1105 and 1110 are placed on the third port of circulators 1115 and 1120, thereby reducing the insertion loss between the PA output and the duplexer 1020. The remainder of Figure 11 is substantially identical to Figure 10 and is not described further.

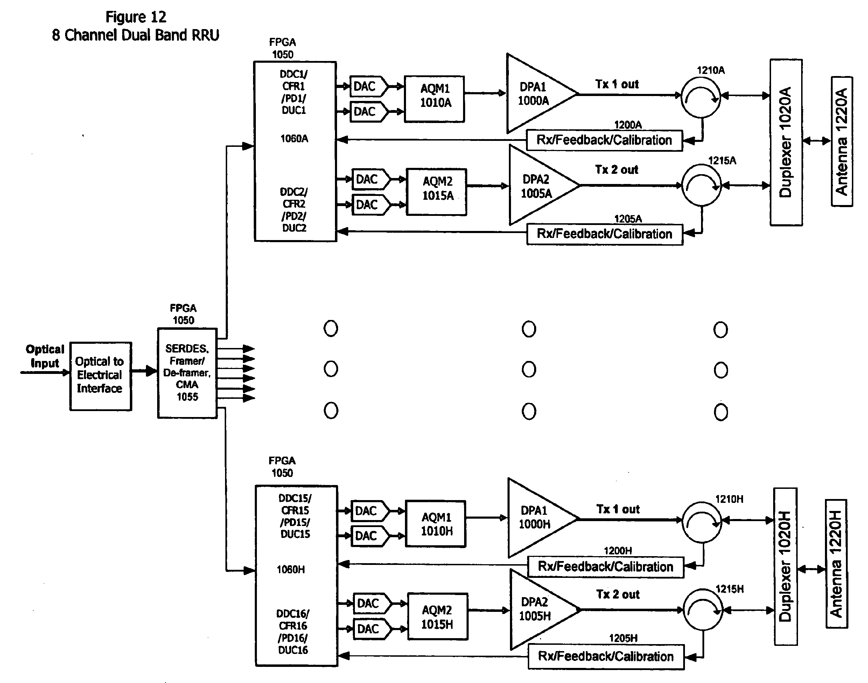

Figure 12 is a block diagram showing an embodiment of an 8 channel dual-band RRU. In this embodiment, the feedback path for each PA 1000A-H and 1005A-H comprises a receiver chain plus a wideband capture chain, indicated at 1200A-H and 1205A-H, respectively, receiving feedback signals from the array of associated PA's through associated circulators 1210A-H and 1215A-H. The receiver chain is utilized when the RRU is switched to a receive mode and corresponds to the receive (Rx) paths shown in Figure 11. The wideband capture chain is utilized for capturing the wideband distortion of the power amplifier, and corresponds to the Feedback Calibration path shown in Figure 11. In an embodiment a channel calibration algorithm is implemented to insure that each power amplifier output is time, phase and amplitude aligned to each other.

**Digital Predistorter Algorithm**

Digital Predistortion (DPD) is a technique to linearize a power amplifier (PA).
Figure 1 shows the block diagram of linear digitally predistorted PA. In the DPD block, a memory polynomial model is used as the predistortion function (Figure 3).

$$z(n) = \sum_{i=0}^{n-1} x_t(n-i)(\sum_{j=0}^{k-1} a_{ij}|x_t(n-i)|^j)$$

where $\alpha_{ij}$ are the DPD coefficients.

In the DPD estimator block, a least square algorithm is utilized to find the DPD coefficients $\alpha_{ij}$, and then transfer them to DPD block. The primary DPD blocks are shown in Figure 4.

**Delay Estimation Algorithm:**

The DPD estimator compares x(n) and its corresponding feedback signal y(n - Δd) to find the DPD coefficients, where Δd is the delay of the feedback path. As the feedback path delay is different for each PA, this delay should be identified before the signal arrives at the coefficient estimation. In this design, the amplitude difference correlation function of the transmission, x(n), and feedback data, y(n), is applied to find the feedback path delay. The correlation is given by

$$C(m) = \sum_{i=0}^{N-1} sign\big(x(i+1) - x(i)\big) sign\big(y(i+m+1) - y(i+m)\big)$$

$$n(delay) = Max(C(m))$$

The delay n that maximizes the correlation C(m) is the feedback path delay.

Since the feedback path goes through analog circuitry, the delay between the transmission and feedback path could be a fractional sample delay. To synchronize the signals more accurately, fractional delay estimation is necessary. To simplify the design, only a half-sample delay is considered in this design, although smaller fractional delays can also be utilized.

To get the half-sample delay data, an upsampling approach is the common choice, but in this design, in order to avoid a very high sampling frequency in the FPGA, an interpolation method is used to get the half-sample delay data. The data with integer delay and fractional delay are transferred in parallel. The interpolation function for fractional delay is

$$y(n) = \sum_{i=0}^{3} c_i x(n+i)$$

in which $c_i$ is the weight coefficient.

Whether the fractional delay path or the integer delay path will be chosen is decided by the result of the amplitude difference correlator. If the correlation result is odd, the integer path will be chosen, otherwise the fractional delay path will be chosen.

**Phase offset Estimation and Correction Algorithm:**

Phase offset between the transmission signal and the feedback signal exists in the circuit. For a better and faster convergence of the DPD coefficient estimation, this phase offset should be removed.

The transmission signal x(n) and feedback signal y(n) can be expressed as

$$x(n) = |x(n)|e^{j\theta_x} \text{ and } y(n) = |y(n)|e^{j\theta_y},$$

The phase offset $e^{j(\theta_x - \theta_y)}$ can be calculated through

$$e^{j(\theta_x - \theta_y)} = \frac{x(n)y(n)^*}{|x(n)||y(n)|}$$

So, the phase offset between the transmission and feedback paths is

$$e^{jo_,} = mean\left(\frac{x(n)y(n)^*}{|x(n)||y(n)|}\right)$$

The feedback signal with the phase offset removed can be calculated by

$$\bar{y}(n) = y(n)e^{jhe}$$

Magnitude correction:

As the gain of the PA may change slightly, the feedback gain should be corrected to avoid the error from the gain mismatch. The feedback signal is corrected according to the function

$$\bar{y}(n) = y(n)\frac{\sum_{i=1}^{N}|x(i)|}{\sum_{i=1}^{N}|y(i)|}$$

The choice of N will depend on the accuracy desired.

**QR_RLS Adaptive Algorithm:**

The least square solution for DPD coefficient estimation is formulated as

$$F(x(n)) = y(n)$$

$$F(x(n)) = \sum_{i=1}^{N}\sum_{j=0}^{K} a_{ij}x(n-i)|x(n-i)|^{j}$$

Define $h_k = x(n-i)|x(n-i)|^j$, $w_k = a_{ij}$, where $k = (i-1)N+$). The least square formulation can be expressed as:

$$\sum_{k=1}^{N\times K} w_k h_k = y(n)$$

In this design, QR-RLS algorithm (Haykin, 1996) is implemented to solve this problem. The formulas of QR_RLS algorithm are

$$\begin{cases} d(i) \triangleq y(i) - h_i\bar{w} \\ \bar{w}_i \triangleq w_i - \bar{w} \\ q_i \triangleq \phi_i^{*/2}[w_i - \bar{w}] \end{cases}$$

where $\phi_i$ is a diagonal matrix, and $q_i$ is a vector.

The QR_RLS algorithm gets the ith moment $\phi_i$ and $q_i$ from its (i - 1)th moment through a unitary transformation:

$$A = \begin{bmatrix} \phi_i^{1/2} & 0 \\ q_i^{*} & e_a^{*}(i)\,\gamma^{\frac{1}{2}}(i) \\ h_i\Phi_i^{-\frac{1}{2}} & \gamma^{\frac{1}{2}}(i) \end{bmatrix} = \begin{bmatrix} \lambda^{1/2}\phi_{i-1}^{*/2} & h_i^{*} \\ \lambda^{1/2}q_{i-1}^{*} & d(i)^{*} \\ 0 & 1 \end{bmatrix}\theta_i$$

$\theta_i$ is a unitary matrix for unitary transformation.

To apply QR_RLS algorithm more efficiently in FPGA, a squared-root-free Givens rotation is applied for the unitary transformation process (E.N. Frantzeskakis, 1994)

$$\begin{bmatrix} a_1 & a_2 & \cdots & a_n \\ b_1 & b_2 & \cdots & b_n \end{bmatrix} = \begin{bmatrix} \sqrt{k_a} & 0 \\ 0 & \sqrt{k_b} \end{bmatrix}\begin{bmatrix} a_1' & a_2' & \cdots & a_n' \\ b_1' & b_2' & \cdots & b_n' \end{bmatrix}$$

$$\begin{bmatrix} a_1' & a_2' & \cdots & a_n' \\ b_1' & b_2' & \cdots & b_n' \end{bmatrix} \theta = \begin{bmatrix} \sqrt{k_a'} & 0 \\ 0 & \sqrt{k_b'} \end{bmatrix} \begin{bmatrix} 1 & a_2'' & \cdots & a_n'' \\ 0 & b_2'' & \cdots & b_n'' \end{bmatrix}$$

$$k_a' = k_a a_1^2 + k_b b_1^2$$

$$k_b' = k_a k_b / k_a'$$

$$a_j' = (k_a a_1 a_j + k_b b_1 b_j)/k_a'$$

$$b_j' = -b_1 a_j + a_1 b_j$$

For RLS algorithm, the $i^{th}$ moment is achieved as below:

$$\begin{bmatrix} \lambda^{1/2}\phi_{i-1}^{*/2} & h_i^* \\ \lambda^{1/2}q_{i-1}^* & \overline{d(i)^*} \\ 0 & 1 \end{bmatrix} \theta_i = \begin{bmatrix} \overline{\phi_i^{1/2}} & 0 \\ \overline{q_i^*} & \overline{e_a^*(i) \gamma^{\frac{1}{2}}(i)} \\ \overline{h_i \Phi_i^{-\frac{*}{2}}} & \gamma^{\frac{1}{2}}(i) \end{bmatrix} \begin{bmatrix} \sqrt{k_a} & 0 \\ 0 & \sqrt{k_b} \end{bmatrix}$$

$w_i$ can be obtained by solving

$$\overline{\Phi^{\frac{*}{2}}}[w_i - \overline{w}] = \overline{q_i}$$

In the iterative process, a block of data (in this design, there are 4096 data in one block) is stored in memory, and the algorithm uses all the data in memory to estimate the DPD coefficient. In order to make the DPD performance more stable, the DPD coefficients are only updated after one block of data are processed. The matrix A will be used for the next iteration process, which will make the convergence faster.

To make sure the performance of the DPD is stable, a weighting factor f is used when updating the DPD coefficient as

$$w_i = f \times w_{i-1} + (1-f)w_i$$

The DPD coefficient estimator calculates coefficients $w_i$ by using QR_RLS algorithm. These $w_i$ are copied to the DPD block to linearize the PA.

**Channel Calibration Algorithm**

The 8 channel RRU in Figure 12 has 16 distinct power amplifiers, indicated at PA's 1000A-H and 1005A-H. Half the power amplifiers are designed for one band and the other for a second band. The bands are hereafter referred to as band A and band B, and occupy two distinct frequencies. The 8 channel RRU uses eight antennas 1220A-H and both bands will coexist on each antenna. In order to maximize performance, each power amplifier's output signal needs to be time, phase and amplitude aligned with respect to each other. The antenna calibration algorithms comprise three distinct approaches: 1) A Pilot Tone is injected into each. PA; 2) a Reference Modulated signal is transmit through each PA; or 3) the Real Time I/Q data is used as the reference signal The Pilot Tone approach injects a single carrier IF tone that is tracked in either the feedback calibration path or the individual PA's receiver. Each transmitter path for band A is time, phase and amplitude aligned with respect to each other, similarly for band B. The Reference Modulated approach utilizes a stored complex modulated signal which is transmitted through each of the band A PA's, similarly for the band B PA's. The transmitters are then time, phase and amplitude aligned with respect to each other. Either the feedback calibration path or the individual receivers can be used for obtaining the PA output signals. The Real Time approach operates on the real-time transmitted signals. This approach utilizes the DPD time alignment, phase and magnitude offset information to synchronize each PA output with respect to each other.

In summary, the RRU system of the present invention enhances the performance in terms of both the efficiency and the linearity more effectively since the RRU system is able to implement CFR, DPD and adaptation algorithm in one digital processor, which subsequently saves hardware resources and processing time. The high power efficiency of RF power amplifiers inside the RRU means that less thermal dissipation mechanism such as heat sinks is needed; therefore, significantly reducing the size and volume of the mechanical housing. This smaller RRU can then enable service providers to deploy the RRU in areas where heavy or large RRU's could not be deployed, such as pole tops, top of street lights, etc. due to lack of real estate, or weight limitation, wind factor, and other safety issues. The RRU system of the present invention is also reconfigurable and field-programmable since the algorithms and power efficiency enhancing features which are embedded in firmware can be adjusted similarly to a software upgrade in the digital processor at anytime.

Moreover, the RRU system is agnostic to modulation schemes such as QPSK, QAM, OFDM, etc. in CDMA, TD-SCDMA, GSM, WCDMA, CDMA2000, and wireless LAN systems. This means that the RRU system is capable of supporting multi-modulation schemes, multi-carriers and multi-channels. The multi-frequency bands benefits mean that mobile operators can deploy fewer RRUs to cover more frequency bands for more mobile subscribers; hence significantly reducing CAPEX and OPEX. Other benefits of the RRU system include correction of PA non-linearities in repeater or indoor coverage systems that do not have the necessary baseband signals information readily available.

Although the present invention has been described with reference to the preferred embodiments, it will be understood that the invention is not limited to the details described thereof. Various substitutions and modifications have been suggested in the foregoing description, and others will occur to those of ordinary skill in the art. Therefore, all such substitutions and modifications are intended to be embraced within the scope of the invention as defined in the appended claims.

**Claims**

1. A dual channel remote radio head unit for wireless communications comprising
   at least two power amplifiers (1000, 1005), each receiving an input signal centered on a separate frequency and each providing as an output an amplified representation of the received input signal,
   at least two feedback sensors, at least one associated with each power amplifier (1000, 1005), wherein the at least two feedback sensors are configured to provide a feedback signal that includes a representation of the noise characteristics of the associated power amplifier (1000, 1005), digital logic (1090) for processing signals, and
   a feedback switch controlled by the digital logic (1060), wherein the feedback switch is configured to connect one of the feedback signals to the digital logic (1060),
   at least two temperature sensors, at least one associated with each power amplifier, wherein the at least two temperature sensors are configured to provide temperature signals that represents the temperature of the associated power amplifier, and
   a temperature switch, controlled by the digital logic, wherein the temperature switch is configured to connect one of the temperature signals to the digital logic (1060), wherein the digital logic is configured to generate predistortion compensation signals appropriate for each of the power amplifiers, wherein the predistortion compensation signals are based at least in part on the connected feedback signal and the connected temperature signal.

2. The dual channel remote radio head of claim 1 further comprising digital logic configured to implement algorithms that ensure that each power amplifier output is time, phase and amplitude aligned to the other power amplifier outputs.

3. The dual channel remote radio head of claim 1 further comprising an optical to electrical interface.

4. The dual channel remote radio head of claim 3 wherein the digital logic (1060) comprises a Serializer/De-serializer (SERDES) module coupled to the optical to electrical interface.

5. The dual channel remote radio head of claim 4 wherein the digital logic (1060) further comprises a crest factor reduction / digital up conversion / digital downconversion / digital predistortion module.

**6.** The dual channel remote radio head of claim 1 further comprising an analog quadrature modulator (1010, 1015) associated with each power amplifier (1000, 1005).

**7.** The dual channel remote radio head of claim 1 further comprising a feedback calibration loop including an adder operable to receive a phase locked loop signal.

**8.** The dual channel remote radio head of claim 1 wherein the phase locked loop signal is associated with one of the at least two power amplifiers (1000, 1005).

**9.** The dual channel remote radio head of claim 1 further comprising:

a switch (1025, 1030) associated with each power amplifier (1000, 1005); and
a duplexer (1020) coupled to the switches (1025, 1030).


**Patentansprüche**

**1.** Zweikanal-Remote-Radio-Head-Unit zur drahtlosen Kommunikation, umfassend
wenigstens zwei Leistungsverstärker (1000, 1005), die jeweils ein auf eine separate Frequenz eingestelltes Eingangssignal empfangen und jeweils ein dem empfangenen Eingangssignal entsprechendes verstärktes Ausgangssignal ausgeben;
wenigstens zwei Feedback-Sensoren, von denen wenigstens einer jedem der Leistungsverstärker (1000, 1005) zugeordnet ist, wobei die wenigstens zwei Feedback-Sensoren dazu ausgebildet sind, ein dem Rauschverhalten des zugeordneten Leistungsverstärkers (100, 1005) entsprechendes Feedback-Signal bereitzustellen,
eine digitale Logik (1060) zur Verarbeitung von Signalen, und
ein von der digitale Logik (1060) gesteuerter Feedback-Schalter, der dazu ausgebildet ist, eines der Feedback-Signale der digitale Logik (1060) zuzuführen,
wenigstens zwei Temperatur-Sensoren, von denen wenigstens einer jedem der Leistungsverstärker zugeordnet ist, wobei die wenigstens zwei Temperatur-Sensoren dazu ausgebildet sind, der Temperatur des zugeordneten Leistungsverstärker entsprechende Temperatur-Signale bereitzustellen, und
ein von der digitale Logik gesteuerter Temperatur-Schalter, der dazu ausgebildet ist, eines der Temperatur-Signale der digitale Logik (1060) zuzuführen, wobei die digitale Logik dazu ausgebildet ist, Vorverzerrungskompensations-Signale für jeden der Leistungsverstärker zu erzeugen, wobei die Vorverzerrungskompensations-Signale wenigstens teilweise auf dem zugeführten Feedback-Signal und dem zugeführten Temperatur-Signal basieren.

**2.** Zweikanal-Remote-Radio-Head-Unit gemäß Anspruch 1, die des Weiteren eine digitale Logik aufweist, die dazu ausgebildet ist, Algorithmen zu implementieren, die gewährleisten, dass jedes Leistungsverstärker-Ausgangssignal bezüglich Zeit, Phase und Amplitude auf die anderen Leistungsverstärker-Ausgangssignale abgestimmt ist.

**3.** Zweikanal-Remote-Radio-Head-Unit gemäß Anspruch 1, die des Weiteren eine Optik/Elektrik-Schnittstelle aufweist.

**4.** Zweikanal-Remote-Radio-Head-Unit gemäß Anspruch 3, wobei die digitale Logik (1060) ein mit der Optik/Elektrik-Schnittstelle verbundenes Serializer/Deserializer-(SERDES)-Modul aufweist.

**5.** Zweikanal-Remote-Radio-Head-Unit gemäß Anspruch 4, wobei die digitale Logik (1060) des Weiteren ein Crest-Faktorreduktions-/Digital-Upconversions-/Digital-Downconversions-/Digital-Vorverzerrungs-Modul aufweist.

**6.** Zweikanal-Remote-Radio-Head-Unit gemäß Anspruch 1, die des Weiteren einen jedem der Leistungsverstärker (1000, 1005) zugeordneten analogen Quadratur-Modulator (1010, 1015) aufweist.

**7.** Zweikanal-Remote-Radio-Head-Unit gemäß Anspruch 1, die des Weiteren eine Feedback-Kalibrierschleife aufweist, welche dazu ausgebildet ist, ein Phase-Locked-Loop-Signal zu empfangen.

**8.** Zweikanal-Remote-Radio-Head-Unit gemäß Anspruch 1, wobei das Phase-Locked-Loop-Signal einem der wenigsten zwei Leistungsverstärker (1000, 1005) zugeordnet ist.

**9.** Zweikanal-Remote-Radio-Head-Unit gemäß Anspruch 1, die des Weiteren einen jedem der Leistungsverstärker (1000, 1005) zugeordneten Schalter (1025, 1030) aufweist, sowie

einen mit den Schaltern (1025, 1030) verbundenen Duplexer (1020).

**Revendications**

1. Unité de tête radio distante à double canal pour des communications sans fil comprenant
   au moins deux amplificateurs de puissance (1000, 1005), chacun recevant un signal d'entrée centré sur une fréquence séparée et chacun fournissant en sortie une représentation amplifiée du signal d'entrée reçu,
   au moins deux capteurs de rétroaction, au moins un étant associé à chaque amplificateur de puissance (1000, 1005), dans laquelle les au moins deux capteurs de rétroaction sont configurés pour fournir un signal de rétroaction qui inclut une représentation des caractéristiques de bruit de l'amplificateur de puissance (1000, 1005) associé, une logique numérique (1060) pour traiter des signaux, et
   un commutateur de rétroaction commandé par la logique numérique (1060), dans laquelle le commutateur de rétroaction est configuré pour connecter l'un des signaux de rétroaction à la logique numérique (1060),
   au moins deux capteurs de température, au moins un étant associé à chaque amplificateur de puissance, dans laquelle les au moins deux capteurs de température sont configurés pour fournir des signaux de température qui représentent la température de l'amplificateur de puissance associé, et
   un commutateur de température, commandé par la logique numérique, dans laquelle le commutateur de température est configuré pour connecter l'un des signaux de température à la logique numérique (1060), dans lequel la logique numérique est configurée pour générer des signaux de compensation de prédistorsion appropriés pour chacun des amplificateurs de puissance, dans laquelle les signaux de compensation de prédistorsion sont basés au moins en partie sur le signal de rétroaction connecté et le signal de température connecté.

2. Unité de tête radio distante à double canal selon la revendication 1, comprenant en outre une logique numérique configurée pour mettre en oeuvre des algorithmes qui garantissent que chaque sortie d'amplificateur de puissance est alignée en temps, en phase et en amplitude sur les autres sorties d'amplificateur de puissance.

3. Unité de tête radio distante à double canal selon la revendication 1, comprenant en outre une interface optique à électrique.

4. Unité de tête radio distante à double canal selon la revendication 3, dans laquelle la logique numérique (1060) comprend un module de sérialisation/désérialisation (SERDES) couplé à l'interface optique à électrique.

5. Unité de tête radio distante à double canal selon la revendication 4, dans laquelle la logique numérique (1060) comprend en outre un module de réduction de facteur de crête/de conversion-élévation de fréquence numérique/de conversion-abaissement de fréquence numérique/de prédistorsion numérique.

6. Unité de tête radio distante à double canal selon la revendication 1, comprenant en outre un modulateur en quadrature analogique (1010, 1015) associé à chaque amplificateur de puissance (1000, 1005).

7. Unité de tête radio distante à double canal selon la revendication 1, comprenant en outre une boucle d'étalonnage de rétroaction incluant un additionneur pouvant fonctionner pour recevoir un signal de boucle à verrouillage de phase.

8. Unité de tête radio distante à double canal selon la revendication 1, dans laquelle le signal de boucle à verrouillage de phase est associé à l'un des au moins deux amplificateurs de puissance (1000, 1005).

9. Unité de tête radio distante à double canal selon la revendication 1, comprenant en outre :

   un commutateur (1025, 1030) associé à chaque amplificateur de puissance (1000, 1005) ; et
   un duplexeur (1020) couplé aux commutateurs (1025, 1030).

RF
Modulated signal or
Baseband signal or
Optical signal
100

Digital
Predistortion
Controller 101
(e.g. FPGA)

Main
PA
102

RF PA output
103

Feedback signal 105

FIG. 1.   Remote Radio Head Unit

EP 2 524 568 B1

Figure 2
8 Channel RRU

EP 2 524 568 B1

x(n)

FIR 1

301

308

z(n)

Σ

x(n)|x(n)|² 
302
FIR 2
303

x(n)|x(n)|⁴
304
FIR 3
305

x(n)|x(n)|⁶
306
FIR 4
307

Figure 3. Polynomial based digital predistorter function

FIG. 4. Digital Predistortion Block Diagram

Figure 5  Analog Quadrature Modulator Compensation Block

Figure 6

Optical Link
CPRI/OBSAI/IR
Interface

Base
Station
Server

700

710

RRU
Sector 1

RRU
Sector 2

710

RRU
Sector 3

710

Figure 7

EP 2 524 568 B1

Figure 8

Figure 9  Digital Hybrid Module

Figure 10 Dual Channel Remote Radio Head

Figure 11 Dual Channel Remote Radio Head

Figure 12
8 Channel Dual Band RRU

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 2009184763 A1
- US 961969 A
- US 61041164 A
- US 92557707 P